# EUROPEAN PATENT APPLICATION

(11) **EP 4 379 558 A1**
(43) Date of publication of application: **05.06.2024**
(21) Application number: 21955420.1
(22) Date of filing: 31.08.2021
(51) Int. Cl.: G06F 11/36

(54) **TEST METHOD AND SYSTEM**

(71) Applicant: Huawei Technologies Co., Ltd., Shenzhen, Guangdong 518129 (CN)
(72) Inventor: CHEN, Canping, Shenzhen, Guangdong 518129 (CN); CHANG, Chenchen, Shenzhen, Guangdong 518129 (CN); LU, Yuanzhi, Shenzhen, Guangdong 518129 (CN); CHEN, Baocheng, Shenzhen, Guangdong 518129 (CN)
(74) Representative: Isarpatent
(86) International application number: PCT/CN2021/115752
(87) International publication number: WO 2023/028858

(57) **Abstract**

Embodiments of this application provide a vehicle test method. A position conversion relationship between a virtual vehicle and a real test vehicle in a simulation scenario is established, an initialization process and a scenario simulation process are designed for a simulation process, different planning & control algorithms are used in different processes, and scenario trigger information is used for switching between the planning & control algorithms, so as to implement a vehicle in loop test with diverse traffic participants, a small site constraint, and a repeatable test result. This helps ensure consistency of tests of an advanced autonomous driving system, to accurately reproduce a key road test scenario. The test method provided in this application may be applied to a test of an intelligent vehicle.

## Description

### TECHNICAL FIELD

This application relates to the field of vehicles, and in particular, to a test method and system.

### BACKGROUND

A highly intelligent autonomous driving system is a development direction of an autonomous driving technology in the future, and testing an intelligent driving system is a key part in a development process of the intelligent driving system. A plurality of technical means, such as software in loop (software in loop, SIL), model in loop (module in loop, MIL), and hardware in loop (hardware in loop, HIL), may be used to accelerate algorithm iteration and test verification of an autonomous driving system. A SIL simulation test is convenient, flexible, repeatable, low-cost, and secure. However, because mathematical modeling for a vehicle is not accurate enough, a simulation result is not consistent with an actual vehicle motion track. A HIL bench is expensive, and it is difficult to consider real vehicle dynamics. A vehicle in loop (vehicle in loop, VIL) test uses a real vehicle in loop, which makes up for inaccuracy of SIL and HIL simulation vehicle dynamics models.

In addition, a road test is a main test means for an advanced intelligent driving system. A road test may encounter extreme scenarios (corner/edge case) with high risks, which cannot be reproduced in the road test. Reconstruction of such key scenarios and fast, efficient, and low-cost vehicle in loop tests are of great significance to algorithm development, iteration, and verification of the intelligent driving system. However, currently, there is no test method for such reconstruction scenarios in a vehicle in loop test, and there is no method for ensuring consistency of VIL test results.

### SUMMARY

This application provides a high-reliability test system that is flexible and convenient, has a low cost, and can ensure a vehicle in loop test.

According to a first aspect, an embodiment of this application provides a method for testing a vehicle. The test method provided in a first possible implementation of the first aspect of this application includes: obtaining first position information, where the first position information is position information of the vehicle; and obtaining second position information based on the first position information, where the second position information is position information of the vehicle in a simulation scenario.

According to the first possible implementation of the first aspect, in a second possible implementation, the obtaining second position information based on the first position information specifically includes: obtaining a position conversion relationship based on the first position information and simulation scenario information; and obtaining the second position information based on the first position information and the position conversion relationship.

By using automatic update of a positioning conversion relationship, the position limitation of a simulation scenario is decoupled, a test is flexible and convenient, test efficiency is improved, VIL test content is enriched, and test costs are reduced.

According to the second possible implementation of the first aspect, in a third possible implementation, after the obtaining second position information based on the first position information, the method further includes: updating the simulation scenario information based on the second position information, where the simulation scenario information includes traffic participant information; and sending the simulation scenario information.

It should be noted herein that, the real vehicle positioning information and the scenario information are used to automatically update scenario loading at any position and a position conversion relationship during a VIL test. In addition, a test site is not limited, and tests with different ground attachment coefficients may be performed, thereby enriching a capability of a VIL test.

According to the second or the third possible implementation of the first aspect, in a fourth possible implementation, the simulation scenario information further includes scenario trigger information.

According to the fourth possible implementation of the first aspect, in a fifth possible implementation, the scenario trigger information is used to switch between test phases, the test phases include a first phase and a second phase, the vehicle uses a first planning and control algorithm in the first phase, and the vehicle uses the second planning and control algorithm in the second phase. The method further includes: switching from the first phase to the second phase based on the scenario trigger information.

It should be noted herein that, in the method provided in this application, the first planning & control algorithm and the second planning & control algorithm that is based on the scenario trigger information are used in a simulation initialization process, to mitigate impact of a human factor in a VIL test process.

According to the fourth or the fifth possible implementation of the first aspect, in a sixth possible implementation, the scenario trigger information includes at least one of the following: vehicle trigger information, traffic participant trigger information, or traffic signal trigger information.

According to the sixth possible implementation of the first aspect, in a seventh possible implementation, the vehicle trigger information includes a specified vehicle motion status, and the vehicle motion status includes at least one of the following: position information of the vehicle, motion information of the vehicle, driving task information, or a status of a subsystem or a part of an ego-vehicle.

According to the sixth or the seventh possible implementation of the first aspect, in an eighth possible implementation, the traffic participant trigger information includes at least one of the following: a specified motion status, a specified position, or a time of appearance in the simulation scenario.

According to any one of the sixth to the eighth possible implementations of the first aspect, in a ninth possible implementation, the traffic signal trigger information includes at least one of the following: a specified traffic signal light signal, a specified traffic sign signal, a specified traffic marking signal, or a specified traffic manager signal.

According to any one of the first to the ninth possible implementations of the first aspect, in a tenth possible implementation, the simulation scenario is obtained based on a simulation scenario library, the simulation scenario library includes a plurality of simulation scenarios, and the plurality of simulation scenarios include a simulation scenario obtained based on road test data.

It should be noted herein that, an initialization process of scenario simulation and a scenario loading process are employed, to ensure scenario consistency by using scenario trigger information, so that impact on a VIL test result caused due to different vehicle models and scenarios can be mitigated.

A second aspect of this application provides a system for testing a vehicle. In a first possible implementation of the second aspect, the system includes: an obtaining module, where the obtaining module is configured to obtain first position information, where the first position information is position information of the vehicle; and a position conversion module, where the position conversion module is configured to obtain second position information based on the first position information, where the second position information is position information of the vehicle in a simulation scenario.

According to the first possible implementation of the second aspect, in a second possible implementation, that the position conversion module is configured to obtain the second position information based on the first position information specifically includes: the position conversion module is configured to obtain a position conversion relationship based on the first position information and simulation scenario information; and the position conversion module is configured to obtain the second position information based on the first position information and the position conversion relationship.

According to the second possible implementation of the second aspect, in a third possible implementation, the vehicle test system further includes a simulation module and a sending module, where the simulation module is configured to: after the position conversion module obtains the second position information based on the first position information, update the simulation scenario information based on the second position information, and the simulation scenario information includes traffic participant information; and the sending module is configured to send the simulation scenario information.

According to the second or the third possible implementation of the second aspect, in a fourth possible implementation, the simulation scenario information further includes scenario trigger information.

According to the fourth possible implementation of the second aspect, in a fifth possible implementation, the scenario trigger information is used to switch between test phases, the test phases include a first phase and a second phase, the vehicle uses a first planning and control algorithm in the first phase, and the vehicle uses a second planning and control algorithm in the second phase.

The system further includes a simulation trigger module, and the simulation trigger module is configured to control the vehicle to enter the second phase from the first phase based on the scenario trigger information.

According to the planning & control algorithm and the algorithm switching module for the initialization process of the VIL test designed in this application, interference caused by a human factor during the VIL test is reduced, and consistency of an ego-vehicle status is ensured when a scenario is triggered, thereby greatly improving repeatability and stability of a plurality of tests.

According to the fourth or the fifth possible implementation of the second aspect, in a sixth possible implementation, the scenario trigger information includes at least one of the following: vehicle trigger information, traffic participant trigger information, or traffic signal trigger information.

According to the sixth possible implementation of the second aspect, in a seventh possible implementation, the vehicle trigger information includes a specified vehicle motion status, and the vehicle motion status includes at least one of the following: position information of the vehicle, motion information of the vehicle, driving task information, or a status of a subsystem or a part of an ego-vehicle.

According to the sixth or seventh possible implementation of the second aspect, in an eighth possible implementation, the traffic participant trigger information includes at least one of the following: a specified motion status, a specified position, or a time of appearance in the simulation scenario.

According to any one of the sixth to the eighth possible implementations of the second aspect, in a ninth possible implementation, the traffic signal trigger information includes at least one of the following: a specified traffic signal light signal, a specified traffic sign signal, a specified traffic marking signal, or a specified traffic manager signal.

In this application, an initialization process of a simulation scenario, a scenario simulation process, scenario trigger information, and trigger information of a traffic participant are employed, so that impact of a vehicle model on a scenario interaction result is reduced, and various trigger information used can ensure consistency of scenario simulation and improve diversity of simulation scenarios.

According to the first possible implementation of the second aspect, in the ninth possible implementation, the simulation scenario is obtained based on a simulation scenario library, the simulation scenario library includes a plurality of simulation scenarios, and the plurality of simulation scenarios include a simulation scenario obtained based on road test data.

A third aspect of this application further provides a computer-readable storage medium. The computer-readable storage medium stores code or instructions, and when the code or the instructions are run, the method according to any one of the first to the tenth implementations of the first aspect is performed.

A fourth aspect of this application further provides a vehicle. In a first possible implementation of the fourth aspect, the vehicle is capable of obtaining simulation trigger information, and switch scenario trigger information from a first planning & control algorithm to a second planning & control algorithm based on the simulation trigger information, where the first planning & control algorithm is used to enable a vehicle status to meet a preset condition, and the second planning & control algorithm is used for a simulation test.

The test method provided in this application may be applied to a complex scenario in which there are a relatively large quantity of traffic participants, with consideration of a complex case in which a plurality of types of participants and a plurality of interactions are encountered in advanced autonomous driving. In addition, iteration, updates, and verification of an intelligent driving system require a same scenario to be repeatable, so as to evaluate and prove capabilities of the system. The test method provided in this application can ensure consistency of a plurality of test results, reducing test costs. In addition, a test vehicle is projected into a simulation scenario by using a position conversion module, and the vehicle in loop test with flexible and convenient site adjustment and good repeatability of the result can be implemented.

### BRIEF DESCRIPTION OF DRAWINGS

FIG. 1 is a schematic diagram of functions of a vehicle according to an embodiment of this application;
FIG. 2 is a schematic diagram of a vehicle architecture according to an embodiment of this application;
FIG. 3 is a schematic diagram of a simulation system architecture according to an embodiment of this application;
FIG. 4 is a schematic flowchart of ego-vehicle information extraction according to an embodiment of this application;
FIG. 5 is a schematic diagram of a position conversion principle according to an embodiment of this application;
FIG. 6 is a schematic diagram of an update of a positioning conversion relationship according to an embodiment of this application;
FIG. 7 is a schematic flowchart of a scenario test according to an embodiment of this application;
FIG. 8 is a schematic diagram of a test process according to an embodiment of this application;
FIG. 9 is a schematic diagram of a test initialization process according to an embodiment of this application;
FIG. 10 is a diagram of a plurality of test speed curves in a road test extraction scenario according to an embodiment of this application; and
FIG. 11 is a diagram of a plurality of test speed curves according to an embodiment of this application.

### DESCRIPTION OF EMBODIMENTS

The following describes embodiments of this application with reference to the accompanying drawings. It is clear that the described embodiments are merely some but not all of embodiments of this application. A person of ordinary skill in the art may learn that, with technology development and emergence of a new scenario, the technical solutions provided in embodiments of this application are also applicable to a similar technical problem.

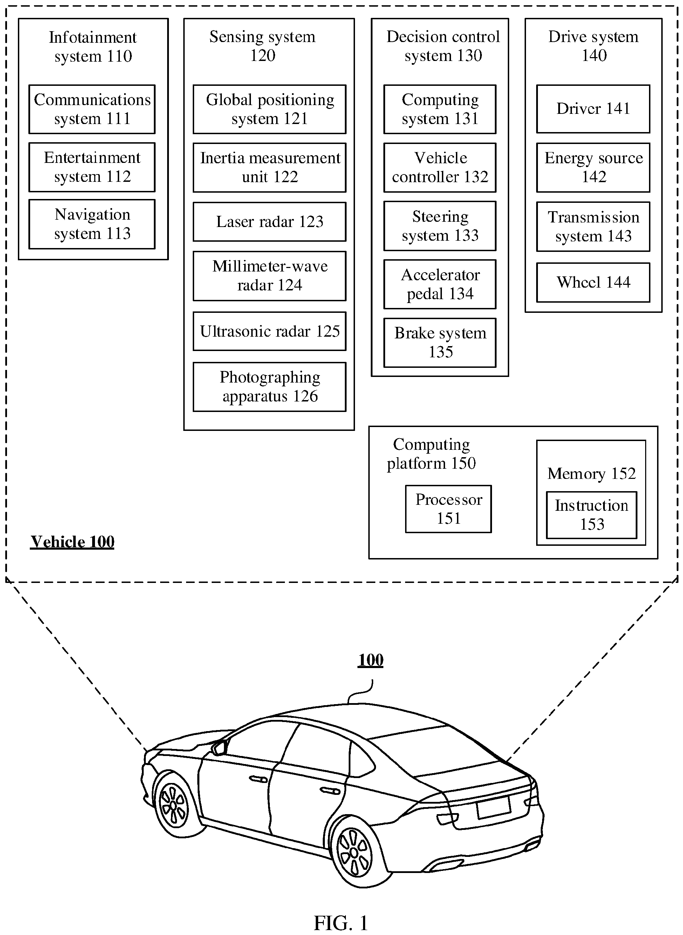

Vehicles are continuously developed and innovated in the tide of electrification, network connection, intelligence, sharing, and the like. FIG. 1 is a schematic diagram of functions of a vehicle 100 according to an embodiment of this application. The vehicle 100 may include various subsystems, such as an infotainment system 110, a sensing system 120, a decision control system 130, a drive system 140, and a computing platform 150. Optionally, the vehicle 100 may include more or fewer subsystems, and each subsystem may include a plurality of components. In addition, all subsystems and components of the vehicle 100 may be interconnected in a wired or wireless manner.

In some embodiments, the infotainment system 110 may include a communications system 111, an entertainment system 112, and a navigation system 113.

The communications system 111 may include a wireless communications system, and the wireless communications system may perform wireless communication with one or more devices directly, or via a communication network. For example, the wireless communications system may use a 3rd generation (3rd generation, 3G) cellular communication technology, such as code division multiple access (code division multiple access, CDMA), or a 4th generation (4th generation, 4G) cellular communication technology, such as a long time evolution (long time evolution, LTE) communication technology, or a 5th generation (5th generation, 5G) cellular communication technology, such as a new radio (new radio, NR) communication technology. The wireless communications system may communicate with a wireless local area network (wireless local area network, WLAN) through WiFi. In some embodiments, the wireless communications system may directly communicate with a device through an infrared link, Bluetooth, or ZigBee (ZigBee). Other wireless protocols, for example, various vehicle communications systems such as the wireless communications system, may include one or more dedicated short range communications (dedicated short range communications, DSRC) devices, and these devices may include public and/or private data communication between vehicles and/or roadside stations.

The entertainment system 112 may include a central control screen, a microphone, and a speaker. A user may listen to a broadcast and play music in a vehicle based on the entertainment system. Alternatively, a mobile phone is connected to a vehicle, and projection of the mobile phone is implemented on the central control screen. The central control screen may be a touchscreen, and the user may perform an operation by touching the screen. In some cases, a voice signal of a user may be obtained by using a microphone, and some control performed by the user on the vehicle 100 is implemented based on analysis of the voice signal of the user, for example, a temperature inside the vehicle is adjusted. In other cases, music may be played to the user by using a speaker.

The navigation system 113 may include a map service provided by a map provider, so as to provide navigation of a driving route for the vehicle 100, and the navigation system 113 may be used together with a global positioning system 121 and an inertia measurement unit 122 of the vehicle. The map service provided by the map provider may be a two-dimensional map or a high-precision map.

The sensing system 120 may include several types of sensors that sense information about an ambient environment of the vehicle 100. For example, the sensing system 120 may include a global positioning system 121 (the global positioning system may be a global positioning satellite (global position satellite, GPS) system, a BeiDou system, or another positioning system), an inertia measurement unit (inertial measurement unit, IMU) 122, a laser radar 123, a millimeter-wave radar 124, an ultrasonic radar 125, and a photographing apparatus 126. The sensing system 120 may further include sensors (such as an in-vehicle air quality monitor, a fuel gauge, and an oil temperature gauge) of an internal system of the monitored vehicle 100. Sensor data from one or more of these sensors can be used to detect an object and corresponding features (a position, a shape, a direction, a speed, and the like) of the object. Such detection and recognition are key functions of safe operation of the vehicle 100.

The positioning system 121 may be configured to estimate a geographical position of the vehicle 100. The inertia measurement unit 122 is configured to sense a position and an orientation change of the vehicle 100 based on an inertial acceleration. In some embodiments, the inertia measurement unit 122 may be a combination of an accelerometer and a gyroscope. The laser radar 123 may sense, by using a laser, an object in an environment in which the vehicle 100 is located. In some embodiments, the laser radar 123 may include one or more laser sources, a laser scanner, one or more detectors, and another system component. The millimeter-wave radar 124 may sense an object in the ambient environment of the vehicle 100 by using a radio signal. In some embodiments, in addition to sensing the object, the radar 126 may be further configured to sense a speed and/or an advancing direction of the object. The ultrasonic radar 125 may sense an object around the vehicle 100 by using an ultrasonic signal. The photographing apparatus 126 may be configured to capture image information of the ambient environment of the vehicle 100. The photographing apparatus 126 may include a monocular camera, a binocular camera, a structured light camera, a panoramic camera, and the like, and the image information obtained by the photographing apparatus 126 may include a static image, and may further include video stream information.

The decision control system 130 includes a computing system 131 that performs analysis and decision making based on information obtained by the sensing system 120. The decision control system 130 further includes a vehicle controller 132 that controls a power system of the vehicle 100, and a steering system 133, an accelerator pedal 134 (including an accelerator pedal of an electric vehicle or a throttle of a fuel vehicle, which is an example name herein), and a brake system 135 that are configured to control the vehicle 100.

The computing system 131 may operate to process and analyze various information obtained by the sensing system 120 to recognize a target, an object, and/or a feature in the ambient environment of the vehicle 100. The target may include a pedestrian or an animal, and the object and/or the feature may include a traffic signal, a road boundary, and an obstacle. The computing system 131 may use technologies such as an object recognition algorithm, a structure from motion (structure from motion, SFM) algorithm, and video tracking. In some embodiments, the computing system 131 may be configured to: draw a map for an environment, track an object, estimate a speed of the object, and so on. The computing system 131 may analyze the various obtained information and obtain a control policy for the vehicle.

The vehicle controller 132 may be configured to perform coordinated control on a power battery and a driver 141 of the vehicle, to improve power performance of the vehicle 100.

The steering system 133 may operate to adjust an advancing direction of the vehicle 100. For example, in an embodiment, the steering system may be a steering wheel system. The accelerator pedal 134 is configured to control an operating speed of the driver 141 and further control a speed of the vehicle 100.

The brake system 135 is configured to control the vehicle 100 to decelerate. The brake system 135 may use friction to slow wheels 144. In some embodiments, the brake system 135 may convert kinetic energy of the wheels 144 into a current. The brake system 135 may also slow down a rotational speed of the wheels 144 in another manner, so as to control the speed of the vehicle 100.

The drive system 140 may include a component that provides power for the vehicle 100 to move. In an embodiment, the drive system 140 may include a driver 141, an energy source 142, a transmission system 143, and wheels 144. The driver 141 may be an internal combustion engine, a motor, an air compression engine, or another type of an engine combination, for example, a hybrid engine including a gasoline engine and a motor, or a hybrid engine including an internal combustion engine and an air compression engine. The driver 141 converts the energy source 142 into mechanical energy.

Examples of the energy source 142 include gasoline, diesel, another petroleum-based fuel, propane, another compressed gas-based fuel, ethanol, a solar panel, a battery, and another source of power. The energy source 142 may also provide energy to another system of the vehicle 100.

The transmission apparatus 143 may transmit mechanical power from the driver 141 to the wheels 144. The transmission apparatus 143 may include a gearbox, a differential, and a drive shaft. In an embodiment, the transmission apparatus 143 may further include another component, for example, a clutch. The drive shaft may include one or more shafts that may be coupled to one or more of the wheels 121.

Some or all functions of the vehicle 100 are controlled by a computing platform 150. The computing platform 150 may include at least one processor 151. The processor 151 may execute instructions 153 stored in a non-transitory computer-readable medium such as a memory 152. In some embodiments, the computing platform 150 may alternatively be a plurality of computing devices that control individual components or subsystems of the vehicle 100 in a distributed manner.

The processor 151 may be any conventional processor, such as a central processing unit (central processing unit, CPU). Alternatively, the processor 151 may further include, for example, a graphic processing unit (graphic processing unit, GPU), a field programmable gate array (field programmable gate array, FPGA), a system on chip (system on chip, SOC), an application-specific integrated circuit (application-specific integrated circuit, ASIC), or a combination thereof. Although FIG. 1 functionally shows the processor, the memory, and other elements of the computer 110 in a same block, a person of ordinary skill in the art should understand that the processor, the computer, or the memory may actually include a plurality of processors, computers, or memories that may or may not be stored in a same physical housing. For example, the memory may be a hard disk drive or another storage medium located in a housing different from that of the computer 110. Therefore, it is understood that a reference to the processor or the computer includes a reference to a set of processors or computers or memories that may or may not operate in parallel. Different from using a single processor to perform the steps described herein, some components such as a steering component and a deceleration component may each include a processor of the component. The processor performs only computation related to a component-specific function.

In various aspects described herein, the processor may be located far away from the vehicle and wirelessly communicate with the vehicle. In another aspect, some processes described herein are performed by a processor disposed inside the vehicle, while others are performed by a remote processor, including performing steps necessary for single manipulation.

In some embodiments, the memory 152 may include the instructions 153 (for example, program logic), and the instructions 153 may be executed by the processor 151 to perform various functions of the vehicle 100. The memory 152 may also include additional instructions, including instructions used to send data to, receive data from, interact with, and/or control one or more of the infotainment system 110, the sensing system 120, the decision control system 130, and the drive system 140.

In addition to the instructions 153, the memory 152 may further store data, such as a road map, route information, a position, a direction, a speed, and other vehicle data of the vehicle, and other information. Such information may be used by the vehicle 100 and the computing platform 150 during operation of the vehicle 100 in autonomous, semi-autonomous, and/or manual modes.

The computing platform 150 may control functions of the vehicle 100 based on inputs received from various subsystems (for example, the drive system 140, the sensing system 120, and the decision control system 130). For example, the computing platform 150 may use an input from the decision control system 130 to control the steering system 133 to avoid an obstacle detected by the sensing system 120. In some embodiments, the computing platform 150 may operate to control many aspects of the vehicle 100 and the subsystems of the vehicle.

Optionally, one or more of the foregoing components may be installed separately from or associated with the vehicle 100. For example, the memory 152 may exist partially or completely separate from the vehicle 100. The foregoing components may be communicatively coupled together in a wired and/or wireless manner.

Optionally, the foregoing components are merely examples. During actual application, components in the foregoing modules may be added or removed according to an actual requirement. FIG. 1 should not be construed as a limitation on this embodiment of this application.

Optionally, the vehicle 100 may be configured to be in a fully or partially autonomous driving mode. For example, the vehicle 100 may obtain ambient environment information of the vehicle by using the sensing system 120, and obtain an autonomous driving policy based on analysis of the ambient environment information, so as to implement fully autonomous driving, or present an analysis result to the user, to achieve partially autonomous driving.

An autonomous driving vehicle traveling on a road, for example, the foregoing vehicle 100, may recognize an object in an ambient environment of the autonomous driving vehicle, to determine an adjustment on a current speed. The object may be another vehicle, a traffic control device, or another type of object. In some examples, each recognized object may be considered independently and may be used to determine a speed to be adjusted by the autonomous driving vehicle based on features of each object, such as a current speed of the object, acceleration of the object, or a spacing between the object and the vehicle.

Optionally, the vehicle 100 or a sensing and computing device (for example, the computing system 131, the computing platform 150) associated with the vehicle 100 may predict a behavior of the recognized object based on a feature of the recognized object and a state (for example, traffic, rain, and ice on a road) of the ambient environment. Optionally, all the recognized objects depend on behaviors of each other, and therefore all the recognized objects may be considered together to predict a behavior of a single recognized object. The vehicle 100 can adjust the speed of the vehicle based on the predicted behavior of the recognized object. In other words, the autonomous driving vehicle can determine, based on the predicted behavior of the object, a state (for example, acceleration, deceleration, or stop) to which the vehicle needs to be adjusted. In this process, another factor may also be considered to determine the speed of the vehicle 100, for example, a horizontal position of the vehicle 100 on a road on which the vehicle travels, curvature of the road, and proximity between a static object and a dynamic object.

In addition to providing an instruction of adjusting the speed of the autonomous driving vehicle, the computing device may further provide an instruction of modifying a steering angle of the vehicle 100, so that the autonomous driving vehicle can follow a given track and/or maintain safe horizontal and vertical distances from an object (for example, a car in a neighboring lane on the road) near the autonomous driving vehicle.

The vehicle 100 may be a car, a truck, a motorcycle, a bus, a boat, an airplane, a helicopter, a lawn mower, an entertainment vehicle, a playground vehicle, a construction device, a tram, a golf cart, a train, or the like, which is not particularly limited in this embodiment of this application.

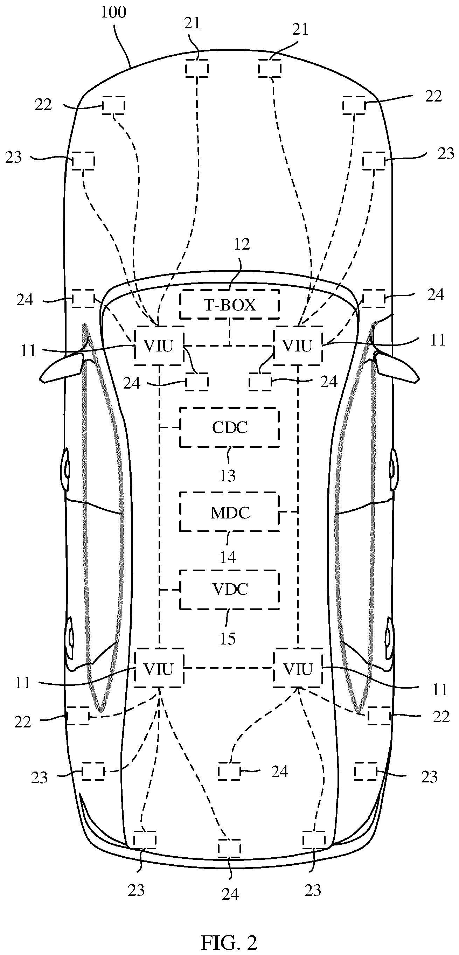

This embodiment of this application may be applied to an architecture shown in FIG. 2. As shown in FIG. 2, the vehicle 100 includes a plurality of vehicle integration units (vehicle integration unit, VIU) 11, a telematic box (telematic box, T-BOX) 12, a cockpit domain controller (cockpit domain controller, CDC), a mobile data center (mobile data center, MDC) 14, and a vehicle domain controller (vehicle domain controller, VDC) 15. The vehicle 100 further includes a plurality of types of sensors disposed on the vehicle, including a laser radar 21, a millimeter-wave radar 22, an ultrasonic radar 23, and a photographing apparatus 24. Each type of sensor may include a plurality of sensors. It should be understood that, although FIG. 2 shows position layouts of different sensors on the vehicle 100, a quantity and a position layout of sensors in FIG. 2 are merely an example. A person skilled in the art may properly select a type, a quantity, and a position layout of the sensors based on a requirement.

FIG. 2 shows four VIUs. It should be understood that, a quantity and a position of VIUs in FIG. 2 are merely examples, and a person skilled in the art may select a proper quantity and position of VIUs according to an actual requirement. The vehicle integration unit VIU 11 provides, for a plurality of vehicle parts, some or all data processing functions or control functions required by a vehicle part. The VIU may have one or more of the following functions.
1. An electronic control function, which means that the VIU is configured to implement the electronic control functions provided by electronic control units (electronic control units, ECUs) inside some or all vehicle parts. For example, the VIU has a control function required by a vehicle part. For another example, the VIU has a data processing function required by a vehicle part.
2. A function that is the same as that of a gateway. That is, the VIU may further have some or all functions that are the same as those of the gateway, for example, a protocol conversion function, protocol encapsulation and forwarding functions, and a data format conversion function.
3. A function of processing data across vehicle parts, that is, performing processing, computation, and the like on data obtained from actuators of a plurality of vehicle parts.

It should be noted that, the data related in the foregoing functions may include running data of an actuator in a vehicle part, for example, a motion parameter of the executor and an operating status of the actuator. The data related in the foregoing functions may further be data collected by using a data collection unit (for example, a sensitive element) of a vehicle part, for example, road information of a road on which the vehicle travels, weather information, or the like that are collected by using the sensitive element of the vehicle. This is not specifically limited in this embodiment of this application.

In the example of the vehicle 100 in FIG. 2, the vehicle 100 may be divided into a plurality of domains (domain), and each domain has an independent domain controller (domain controller). Specifically, in FIG. 2, two domain controllers are shown: a cockpit domain controller CDC 13 and a vehicle domain controller VDC 15.

The cockpit domain controller CDC 13 may be configured to implement function control in a cockpit area of the vehicle 100. Vehicle components in the cockpit area may include a head-up display (head-up display, HUD), a dashboard, a radio, a central control screen, a navigation system, a camera, and the like.

The vehicle domain controller VDC 15 may be configured to coordinate and control the power battery and the driver 141 of the vehicle, so as to improve power performance of the vehicle 100. In some embodiments, the vehicle controller 132 in FIG. 1 may implement various functions of the VDC.

FIG. 2 further shows a telematic box T-BOX 12 and a mobile data center MDC 13. The T-BOX 12 may be configured to implement communication connections between the vehicle 100 and internal and external devices of the vehicle. The T-BOX may obtain in-vehicle device data by using a bus of the vehicle 100, or may be communicatively connected to a mobile phone of a user by using a wireless network. In some embodiments, the T-BOX 12 may be included in the communications system 111 in FIG. 1. The mobile data center MDC 13 is configured to output execution control instructions such as driving, transmission, steering, and braking based on core control algorithms such as environment sensing and positioning, intelligent planning and decision making, and vehicle motion control, thereby implementing automatic control of the vehicle 100, and further implementing human-machine interaction of vehicle driving information by using a human-machine interaction interface. In some embodiments, the computing platform 150 in FIG. 1 may implement various functions of the MDC 13.

Four VIUs 11 in FIG. 2 form a ring topology connection network, each VIU 11 is communicatively connected to a sensor at a nearby position of the VIU, and the T-BOX 12, the CDC 13, the MDC 14, and the VDC 15 are communicatively connected to the ring topology connection network of the VIU. The VIU 11 may obtain information from each sensor, and report the obtained information to the CDC 13, the MDC 14, and the VDC 15. The VDC 15 may alternatively communicate with each other by using the ring topology network, the T-BOX 12, the CDC 13, the MDC 14.

It should be understood that, the ring topology connection network is merely an example, and a person skilled in the art may select another proper VIU connection manner according to a requirement.

The connections between the VIUs may be, for example, an Ethernet (Ethernet), the connections between the VIUs and the T-BOX 12, the CDC 13, the MDC 14, and the VDC 15 may be, for example, an Ethernet or a quick peripheral component interconnect express (peripheral component interconnect express, PCIe) technology, and the connections between the VIUs and the sensors may be, for example, a controller local area network (controller area network, CAN), a local interconnect network (local interconnect network, LIN), a FlexRay, and a media oriented system transport (media oriented system transport, MOST).

With reference to the foregoing description, an embodiment of this application provides a simulation test system. The system is based on a scenario trigger mechanism, has high reliability, can implement a vehicle in loop test, and may be used in a simulation test of the vehicle 100 shown in FIG. 1 or FIG. 2.

In a possible implementation, the simulation test system provided in this embodiment of this application may include an intelligent driving central processing unit, an in-vehicle positioning and sensing device unit, a data platform, and a simulation platform.

In a possible implementation, the intelligent driving central processing unit may be an autonomous driving system, may be the computing platform shown in FIG. 1, may be the MDC platform shown in FIG. 2, or may be another domain controller responsible for autonomous driving or intelligent driving assistant computing. This is not limited in this application.

In a possible implementation, the positioning and sensing device unit in the simulation test system provided in this embodiment of this application may be a sensor or an apparatus in the sensing system 120 shown in FIG. 1.

In a possible implementation, the data platform and the simulation platform may be servers provided by a test site, or may be cloud servers whose geographical positions are decoupled from the test site. The cloud servers may be actual servers, or may be virtual servers. This is not limited in this application.

Embodiments of this application mainly describe the simulation test system provided in this application from the following aspects.

First, a system architectural diagram of the solutions provided in this application is described.

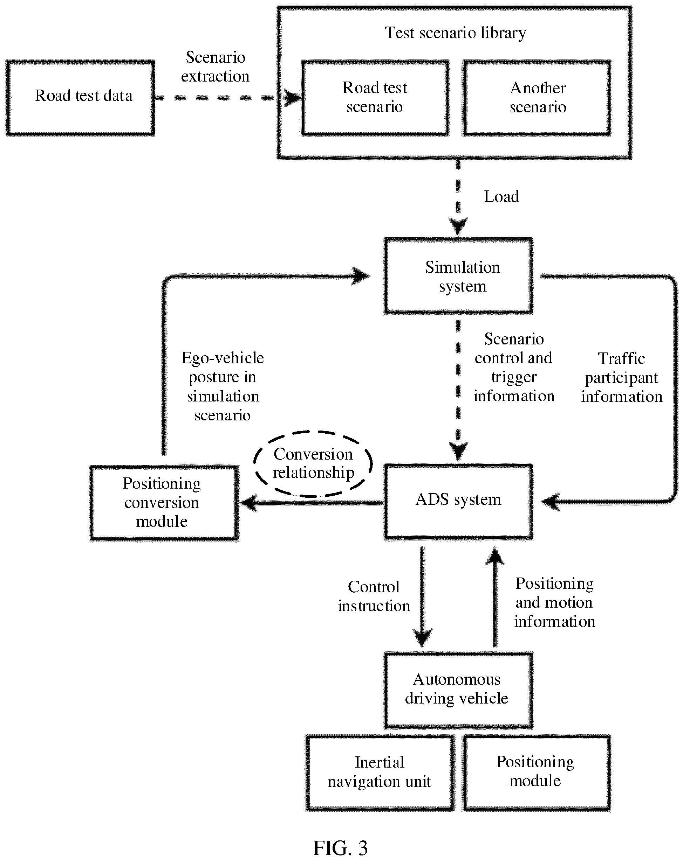

FIG. 3 is a schematic diagram of a simulation system architecture according to an embodiment of this application. As shown in FIG. 3, the simulation system architecture may include several aspects such as a test scenario library, a simulation system, an autonomous driving system (ADS-Auto Driving System), and an autonomous driving vehicle. It should be noted that, the test method provided in this embodiment of this application may be applied to a test of an autonomous driving system. In addition, the test method provided in this embodiment of this application may further be used to test another system such as an advanced driving assistance system (Advanced Driving Assistance System). A type of a to-be-tested system is not limited in this application. In addition, it should be further noted that, the scenario described in this specification of this application may be understood as a set of a plurality of types of information and constraint conditions, such as a vehicle and an environment around the vehicle, a road, weather, a traffic signal, and a traffic participant. For example, the scenario may be an expressway scenario, an urban road scenario, an off-road road scenario, a desert road scenario, or the like that is classified based on a road type. For another example, the scenario may be a gas station scenario, a shopping center scenario, a parking lot scenario, or the like that is classified based on a function or a service. In addition, the scenario may be an autonomous driving scenario, an automatic parking scenario, an emergency braking scenario, an anti-lock scenario, or the like that is classified based on a driving task or a vehicle function application. The simulation scenario described in this specification of this application may be a scenario presented by using a computer, for example, a scenario in a real world may be simulated by using a computer, or a scenario in a real world is reproduced by collecting scenario data in the real world and using a simulation tool. This is not limited in this application.

As shown in FIG. 3, the test scenario library includes a plurality of scenarios. The scenario in the test scenario library may be a scenario obtained through a road test, or may be a scenario obtained in another way. For example, data may be collected through a real vehicle road test, road test data is extracted to form a road test scenario, and the scenario obtained through the road test is added to the test scenario library. In addition, the test scenario library may also include another publicly available scenario, for example, a scenario provided by a shared platform, or a scenario obtained in another commercially available way.

It should be noted that the test scenario library may be stored locally, for example, in a simulation test system or a workstation. In addition, the test scenario library may further be stored on the cloud server. The scenario library may be updated in real time and shared by a plurality of simulation test platforms.

As shown in FIG. 3, in a possible implementation, the simulation scenario information described in this application includes scenario control information, scenario trigger information, and traffic participant information.

The scenario control information may come from a scenario control file. The scenario control file may include data of a to-be-simulation scenario. When the scenario control information is loaded, a road, a traffic facility, an obstacle, a traffic participant, and the like in the simulation scenario may be generated. The scenario control information may be understood as information required for a computer or a simulator to generate a simulation scenario, or information such as an environment, a road, a traffic facility, and an obstacle in the scenario.

The scenario trigger information may be used to switch between planning and control algorithms. The planning and control algorithm is also referred to as a planning & control algorithm in this specification of this application. The planning & control algorithm is used for planning and control of a vehicle, so that the vehicle can travel along a path of the planning and control, or perform an action such as acceleration or braking based on a result of the planning and control. A specific driving task or an action performed by a vehicle is not limited in this application. When a specific condition is triggered, or a condition indicated by the scenario trigger information is met, the simulation test may be performed by switching the control algorithm.

In a possible implementation, the scenario trigger information provided in this embodiment of this application may include ego-vehicle trigger information, traffic participant trigger information, traffic signal trigger information, and the like.

The ego-vehicle trigger information (or the vehicle trigger information) may be status information when the ego-vehicle meets a specific condition. It should be noted that the vehicle described in this specification of this application is sometimes described as an ego-vehicle. Unless otherwise specified, the two may be understood as having a same meaning.

In a possible implementation, the ego-vehicle trigger information may be information that one or more aspects such as a position, a motion status, and a driving task of the autonomous driving vehicle meet a specific condition. The motion status may include a position, a speed, an acceleration, and the like. For example, the ego-vehicle trigger information may be that a position of the vehicle is a point A. For another example, the ego-vehicle trigger information may be that a speed of the vehicle reaches 5 m/s. For another example, the ego-vehicle trigger information may be that an acceleration of the vehicle reaches 2 m/s². For another example, the trigger information may be that the vehicle arrives at a point A and a speed reaches 5 m/s. For another example, the trigger information may be that the vehicle arrives at a point A and an acceleration reaches 2 m/s². For another example, the trigger information may be that the vehicle arrives at point A, a speed reaches 5 m/s, and an acceleration reaches 2 m/s². The ego-vehicle trigger information may be used for ego-vehicle path planning, control of a motion status of an autonomous driving vehicle at a start moment of a simulation scenario, and the like.

In another possible implementation, the ego-vehicle trigger information may alternatively be a status of a subsystem or a part of the ego-vehicle; for example, may be a status of an audible/visual signal sent by the ego-vehicle, including a left-turn signal light indication, a right-turn signal indication, a brake signal indication, an emergency or fault signal indication, a horn signal, a yield signal, an autonomous driving status signal, an operating status signal, another indication signal, or the like; and for another example, may be a vehicle door/window status, an air conditioner status, a motor status, a battery status, a thermal management system status, or the like. Alternatively, the ego-vehicle trigger information may further be a vehicle suspension status, a brake system status, a steering system status, and the like. The ego-vehicle trigger information may be information indicating that a status of an ego-vehicle, a subsystem, a part, or the like meets a specific condition. This is not limited in this application.

In another possible implementation, the ego-vehicle trigger information may further be driving task information, for example, may be an autonomous driving task, or may be an automatic emergency braking task or another task. This is not limited in this application.

The traffic participant trigger information is information that a status of the traffic participant meets a specific condition. The traffic participant may include another motor vehicle, a non-motor vehicle, a pedestrian, an animal, and the like. The traffic participant is not limited in this embodiment of this application. The traffic participant may affect the planning, decision making, and control of the ego-vehicle. The traffic participant trigger information may be used to control an occasion at which the traffic participant is injected into the simulation scenario. When a trigger condition is met, a specific traffic participant may be injected into the simulation scenario. The traffic participant trigger information may be used to update a scenario. When the trigger condition is met, information of the simulation scenario information is updated.

In a possible implementation, the traffic participant information may be a position, a speed, an acceleration, and a combination of these variables of another motor vehicle, a non-motor vehicle, a pedestrian, an animal, and the like. For details, refer to descriptions of the ego-vehicle trigger information. Details are not described herein again. In another possible implementation, the traffic participant trigger information may be information that a status of a subsystem or a part of another motor vehicle meets a specific condition, or may be information that a status of a subsystem or a part of another non-motor vehicle meets a specific condition, for example, may be a status of an audible and visual signal sent by the another motor vehicle or the non-motor vehicle, including a left-turn signal light indication, a right-turn signal indication, a brake signal indication, an emergency or fault signal indication, a horn signal, a yield signal, an autonomous driving status signal, an operating status signal, another indication signal, or the like; and for another example, may be a vehicle door/window status, an air conditioner status, a motor status, a battery status, a thermal management system status, or the like. The traffic participant trigger information may further be an action, a gesture, a voice, an expression, or the like of a pedestrian.

The traffic signal trigger information may be that a traffic signal changes to a state, or a new traffic signal appears. The traffic signal may include a signal of a traffic signal light, a signal of a traffic commander or a traffic manager, a traffic sign signal, a traffic marking signal, and the like. The signal of the traffic signal light may include a green light, a yellow light, a red light, an arrow light, a crossing light, a warning light, a motor vehicle signal light, a non-motor vehicle signal light, and the like. The traffic sign signal may include a speed limit indication signal, a speed limit cancellation indication signal, a road guide signal, a lane change indication signal, a warning sign, a prohibition sign, an indication sign, a distance sign, a road construction safety sign, and the like. The traffic marking signal may include an indication marking, a forbidden marking, a warning marking, and the like. The signal of the traffic manager may include stop, going straight, left turn, right turn, waiting, lane change, slowdown, stop by the side, and the like.

In a possible implementation, the traffic signal trigger information may be that a status of the traffic signal light changes to indicating that passing is allowed, or a status of the traffic signal light changes to indicating that passing is forbidden. In another possible implementation, the traffic signal trigger information may be that a speed limit 60 km/h sign appears, or a speed limit 60 km/h cancellation sign appears. In another possible implementation, the traffic signal trigger information may be that a lane line used to indicate traffic flow combination appears, or a tidal lane sign indicating switching of a first lane from a straight travel lane to a left-turn lane. In another possible implementation, the traffic signal trigger information may be that a traffic manager indicates to stop, or a traffic manager indicates to travel to a first place. The traffic signal trigger information may be used to control a traffic signal in the simulation scenario.

It should be noted that the scenario trigger information provided herein is merely an example, and this is not limited in this application. It should be understood that other implementations that can be figured out by a person skilled in the art without creative efforts shall fall within the scope of the technical solutions of this application.

As shown in FIG. 3, after the simulation system used in this application loads a simulation scenario, a positioning conversion module obtains a conversion relationship between the simulation scenario and a real scenario of an ego-vehicle position by using scenario control information and current positioning information of a test vehicle, and maps the ego-vehicle to the simulation scenario. It may be understood that, when the ego-vehicle moves at an actual test site, a position of a simulated vehicle to which the ego-vehicle is mapped in the simulation scenario also changes based on a position of the ego-vehicle in the actual site and the position conversion relationship. The simulation system updates the simulation scenario by using the scenario trigger information, the traffic participant information, and the position information after ego-vehicle positioning and projection. In addition, the simulation system sends the simulation scenario information to the vehicle in real time, for example, may send the simulation scenario information to an autonomous driving system or a driving assistance system of the vehicle. Through the foregoing process, the update of the simulation scenario and the vehicle in loop test are implemented.

It should be noted herein that information transmission between the simulation system and the autonomous driving system may be completed in a wired or wireless manner, for example, may be completed in a wireless communication manner that may be used by the communications system shown in FIG. 1. Details are not described herein again. The simulation scenario information may be transmitted to the vehicle in a wireless manner. Alternatively, in another possible implementation, the simulation system may be installed on a vehicle, and is connected to the vehicle in a wired manner. The simulation system sends the simulation scenario information to the vehicle through a wired connection. Optionally, the simulation system may further communicate with a cloud, and refresh the simulation scenario library in the simulation system by using a simulation scenario library stored in the cloud.

It should be noted that, in this specification of this application, the vehicle is sometimes described as an ego-vehicle. Unless otherwise specified, the two may be understood as a same meaning.

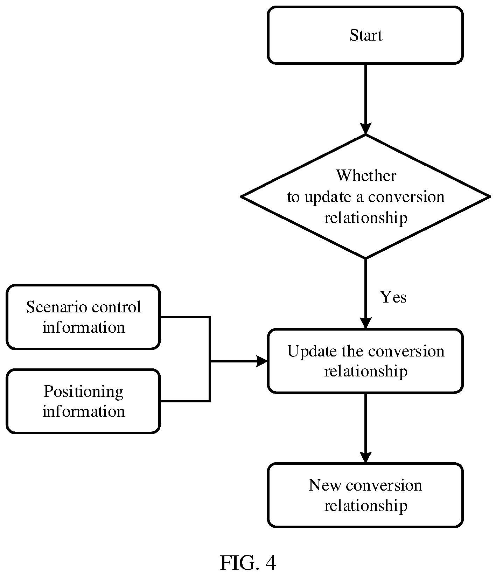

FIG. 4 is a flowchart of a principle of a position conversion module and an update of a conversion relationship according to an embodiment of this application. As shown in FIG. 4, in a process of performing a vehicle in-loop test, after a simulation system loads a simulation scenario, the simulation system determines whether to update a position conversion relationship. If the update is required, the simulation system obtains, based on the simulation scenario information and positioning information at the current moment, a new position conversion relationship. In a possible implementation, specifically, the simulation system may obtain a new position conversion relationship based on scenario control information and positioning information of the vehicle. After obtaining the new position conversion relationship, the simulation system obtains, based on the position information of the vehicle and the new position conversion relationship, position information of a simulated vehicle in the simulation scenario.

In a possible implementation, the position information of the vehicle may include a position of the vehicle and a posture of the vehicle at the position, for example, may be an orientation of the vehicle, for example, eastward, westward, 5 degrees southward to east, or 3 degrees northward to east.

In a possible implementation, a position change and a motion status of the vehicle at the actual test site completely correspond to a position and a motion relationship of the vehicle that are projected in the simulation scenario. For example, the vehicle moves from a first position to a second position at the actual test site, and a position of the vehicle that is projected in the simulation scenario changes from a third position to a fourth position. In addition, a change process of a motion status in a process in which the vehicle moves from the first position to the second position in the simulation scenario is completely the same as a change process of a motion status in a process in which the vehicle moves from the third position to the fourth position at the actual test site. In addition, a relative position relationship between the first position and the second position at the actual test site is completely the same as a relative position relationship between the third position and the fourth position in the simulation scenario.

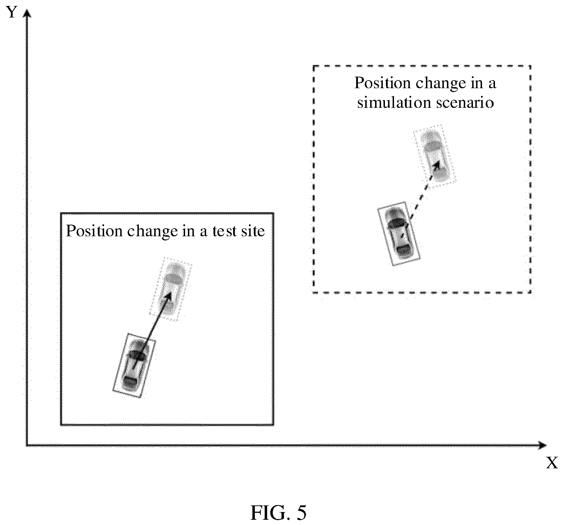

FIG. 5 is a schematic diagram of a position conversion principle. As shown in FIG. 5, in another possible implementation, a position change and a motion status of a vehicle at an actual test site may not completely correspond to a position and a motion relationship of a vehicle that are projected in a simulation scenario. For example, a position change of the vehicle that is projected in the simulation scenario may be different from a position change of the vehicle at the actual test site. As shown in FIG. 5, at the test site, the vehicle moves from a first position shown by a solid-line box to a second position shown by a dashed-line box; and in the simulation scenario, the vehicle moves from a third position shown by a solid-line box to a fourth position shown by a dashed-line box. As shown in FIG. 5, a vector in which the vehicle moves from the first position to the second position at the actual test site is shown by a solid-line arrow, and a vector in which the vehicle moves from the third position to the fourth position in the simulation scenario is shown by a dashed-line arrow. In a possible implementation, a vector shown by a solid-line arrow may be different from a vector shown by a dashed-line arrow, and a position change of the vehicle at an actual test site may be different from a position change in a simulation scenario. As shown in FIG. 5, a position change process in a process in which the vehicle changes from the third position to the fourth position in the simulation scenario may also be different from a position change process in a process in which the vehicle changes from the first position to the second position in the test site.

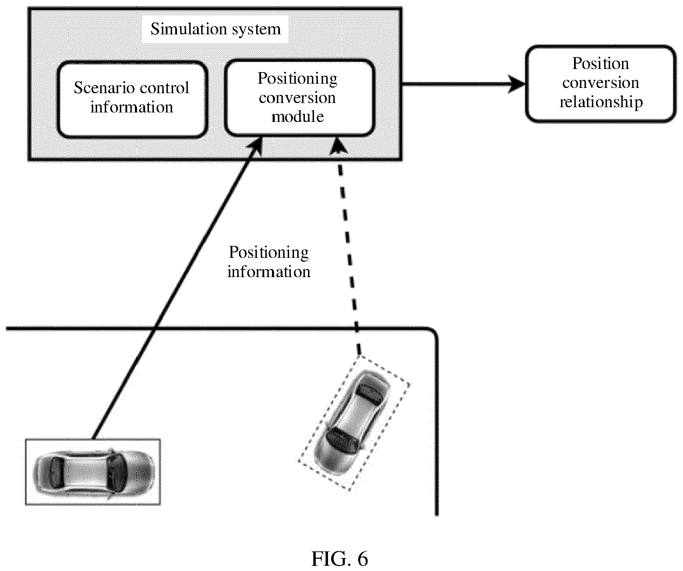

FIG. 6 is a schematic diagram of a principle of updating a position conversion relationship in a process of a plurality of simulation scenario tests in a site test. The simulation system includes a positioning conversion module, and the positioning conversion module is configured to obtain, based on the position information of the vehicle and the simulation scenario information, the position conversion relationship. In a possible implementation, the simulation scenario information includes scenario control information. The positioning conversion module may be configured to obtain, based on the position information of the vehicle and the scenario control information, the position conversion relationship. For example, at a position shown by a solid-line box, the simulation system obtains, based on the vehicle positioning information and the scenario control information, a first position conversion relationship; and at a position shown by a dashed-line box, the simulation system obtains, based on new vehicle positioning information and the scenario control information, a second position conversion relationship. The first position conversion relationship may be different from the second position conversion relationship. Therefore, in a same test, a position conversion relationship between a position of the vehicle in the test site and a position of the vehicle in the simulation scenario may be the same or may be different. In a plurality of different tests, a position conversion relationship between a position of the vehicle in the test site and a position of the vehicle in the simulation scenario may be the same or may be different. In addition, in the test method provided in this embodiment of this application, the position conversion relationship may change based on an actual situation of a test site. For example, when a test site area is relatively small, the position conversion relationship is adjusted, so that a vehicle can complete, at a test site with a relatively small area, a test that is completed in a simulation scenario with a relatively large site area. The position conversion module provided in this embodiment of this application can implement a vehicle in loop test that is not restricted by a site, thereby bringing higher flexibility to the test.

For the tested simulation scenario, the traffic participants are controlled to move based on a preset track; a position relationship between a test vehicle and a virtual autonomous driving vehicle in the simulation system is established by using the scenario control information and the positioning information of the test vehicle, so that the test is not restricted by the scenario; and the initialization process and simulation process of the scenario are designed based on the scenario trigger information, and different planning & control algorithms are used in the scenario initialization phase and scenario simulation phase, thereby eliminating human interference and ensuring repeatability of a plurality of test results.

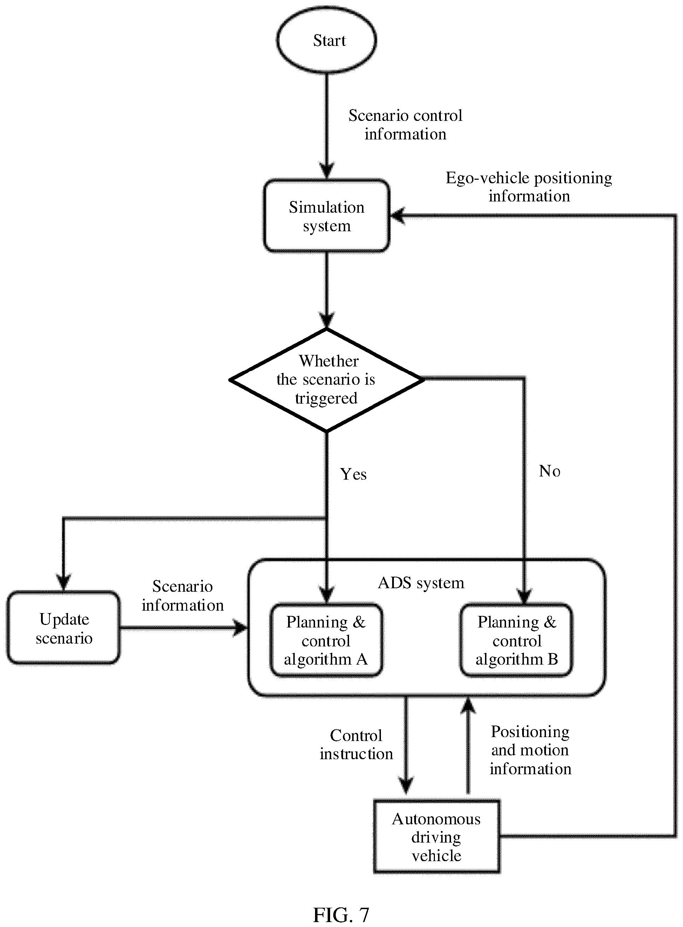

FIG. 7 is a schematic flow of a simulation test according to an embodiment of this application. As shown in FIG. 7, in a phase of loading a simulation scenario, after loading scenario control information, a simulation system obtains the simulation scenario. The simulation system updates status information (a position, a speed, an orientation, and the like) of a traffic participant in the simulation scenario by using ego-vehicle positioning information and scenario trigger information, and sends the simulation scenario information to a vehicle. In a possible implementation, the simulation scenario information may be sent to an autonomous driving system, and the sent scenario information may be recognized by an autonomous driving system, so that the autonomous driving system considers that the vehicle travels in a real-world scenario corresponding to the simulation scenario. In a possible implementation, the autonomous driving system of the vehicle selects different planning and control algorithms based on the scenario trigger status, and sends a control instruction to the vehicle. The scenario trigger status may include that the scenario is triggered and that the scenario is not triggered. The vehicle continuously sends positioning and motion information to the autonomous driving system for computation of an autonomous driving or driving assistance function. In addition, the vehicle sends positioning information of an ego-vehicle to the simulation system, and the simulation system updates the scenario based on the positioning information of the ego-vehicle, and detects whether the scenario trigger condition is met.

Scenario information used in this application includes ego-vehicle related information, scenario trigger information, and traffic participant information in a scenario. The ego-vehicle related information is used to update the positioning conversion relationship, the scenario trigger information is used to switch between planning and control algorithms, and the traffic participant information is used to update the scenario. It should be noted that the planning and control algorithm in this application is also referred to as a planning & control algorithm, and meanings of the two algorithms are the same.

As shown in FIG. 7, a planning & control algorithm A is used in a scenario test phase to test an autonomous driving system, and a planning & control algorithm B is used in a scenario initialization phase to enable an ego-vehicle to reach a scenario trigger object state. Specifically, as shown in FIG. 7, when the scenario is not triggered, or when the scenario trigger condition is not met, the autonomous driving system uses the planning and control algorithm B to implement an initialization process. In a possible implementation, the planning and control algorithm B may be used to enable the vehicle to reach a motion status or positioning required by the scenario trigger condition. As shown in FIG. 7, when a vehicle meets a scenario trigger condition, the autonomous driving system uses the planning & control algorithm A to enter a scenario simulation test process. In a possible implementation, the planning and control algorithm A may be an algorithm to be simulated and tested. The simulation of the scenario can be completed by repeating the foregoing simulation process.

The scenario trigger information mentioned in this application may be a position, a speed, an acceleration, and a combination of these variables of the autonomous driving vehicle. Reference may be made to the foregoing description, and details are not described herein again.

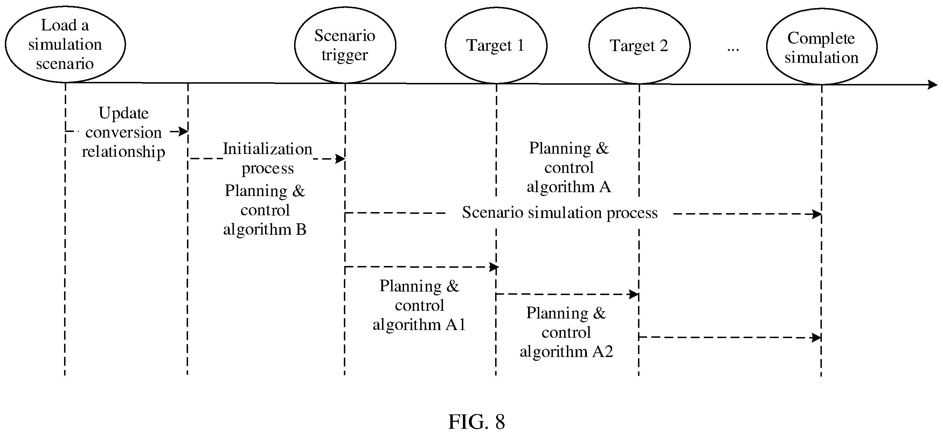

FIG. 8 is a schematic diagram of a process of a simulation test method according to an embodiment of this application. As shown in FIG. 8, the test method provided in this application may include the following processes: a simulation scenario loading process, an initialization process, and a scenario simulation process. In this application, the process is sometimes referred to as a phase. Details are described below.

First, the simulation scenario is loaded, and the position conversion relationship is updated. The scenario loading may be implemented by the simulation system by obtaining the simulation scenario based on the scenario control information. Then, the initialization process is performed, and the planning & control algorithm B is used to enable the vehicle to meet a trigger condition in the simulation scenario. When the vehicle meets a trigger condition in the simulation scenario, the scenario simulation process starts. Next, in the scenario simulation process, the autonomous driving system executes the planning & control algorithm A. In a possible implementation, when the scenario simulation process includes a plurality of processes, different planning & control algorithms may be used. The scenario simulation process may further include a first test object, a second test object, a third test object, and the like. The planning & control algorithm for each object may also be different. For example, a planning & control algorithm C is used for testing under the first test object, and a planning & control algorithm D is used for testing under the second test object. A planning & control algorithm E is used for testing under the third test object. The rest can be deduced by analogy until all test objects are tested and the simulation test is completed.

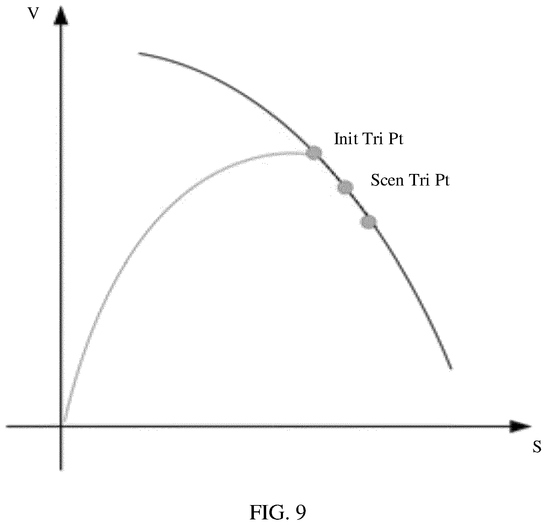

FIG. 9 is a schematic diagram of an initialization process according to an embodiment of this application.

In a possible implementation, a horizontal coordinate represents time, and a vertical coordinate represents a speed. For example, the scenario trigger condition may be that a speed of the vehicle in the simulation scenario meets a specific condition. As shown in FIG. 9, the vehicle starts to accelerate from being stationary, a speed increases, based on a curve, from 0 to an initial trigger point shown by "init Tri Pt" in the figure, and decelerates, based on a curve, to a scenario trigger point that meets a scenario trigger condition, as shown by "seen Tri Pt" in FIG. 9. It should be noted that, in the initialization process, the vehicle uses the planning & control algorithm B to enable the vehicle to meet the trigger condition. For example, when the trigger condition is that the speed of the vehicle reaches 10 m/s, the planning & control algorithm B may be a control algorithm that accelerates the vehicle by using a constant acceleration, for example, may accelerate the vehicle by using an acceleration of 2 m/s² until the vehicle reaches the speed of 10 m/s. The planning & control algorithm B may further be an acceleration control algorithm for an acceleration change. A specific implementation of the planning & control algorithm B is not limited in this application. As shown in FIG. 9, the acceleration of the vehicle under the planning & control algorithm changes, the acceleration is large at the beginning moment, and then the acceleration gradually decreases.

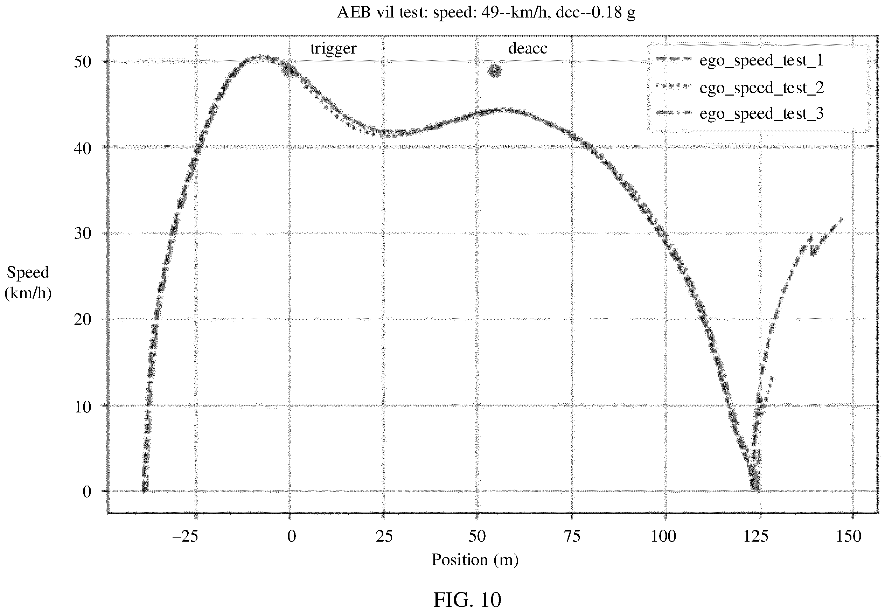

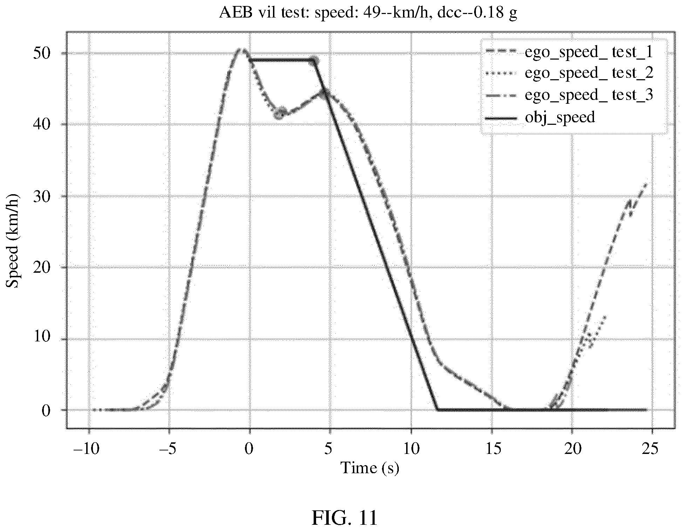

FIG. 10 and FIG. 11 are schematic diagrams of data collected by an actual vehicle in an automatic emergency braking (automatic emergency braking, AEB) function simulation test. In FIG. 10, a horizontal coordinate represents a position, and a vertical coordinate represents a speed. In FIG. 11, a horizontal coordinate represents time, and a vertical coordinate represents a speed.

As shown in FIG. 10, in a possible implementation, in the simulation test method provided in this embodiment of this application, a scenario trigger condition that a position reaches a target position may be used, for example, a trigger position point shown by "trigger" in FIG. 10. A curve shown by a negative half axis of the horizontal coordinate in FIG. 10 indicates an initialization process, a scenario trigger condition is met at a position at which the horizontal coordinate is 0, and a simulation test is performed on a positive half axis of an abscissa axis.

In another possible implementation, as shown in FIG. 11, in the simulation test method provided in this embodiment of this application, a speed reaching a target speed may be used as a scenario trigger condition. A curve shown by a negative half axis of a horizontal coordinate in FIG. 11 is an initialization process, a scenario trigger condition is met at a position in which the horizontal coordinate is 0, and a simulation test is performed on a positive half axis of an abscissa axis.

As shown in FIG. 10 and FIG. 11, curves in a plurality of simulation tests have a same shape and height. Therefore, a good effect brought by the test method provided in this embodiment of this application can be reflected, and consistency of all tests can be ensured in a process of a plurality of tests. In this way, a more accurate test result can be provided, and it is convenient to perform a simulation test on vehicles in different autonomous driving systems, different vehicle models, and different conditions.

In conclusion, in the simulation test system provided in this embodiment of this application, the positioning conversion module is introduced in the vehicle in loop test, so that the test is convenient and flexible, and the simulation test is not limited to the test site. In addition, trigger information of the simulation scenario is introduced, so that different planning & control algorithms can be used in different phases, thereby mitigating impact of a human factor on the vehicle in loop test, and ensuring reliability and consistency of a plurality of tests.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the possible implementation.

## Claims

1. A method for testing a vehicle, wherein the method comprises:
obtaining first position information, wherein the first position information is position information of the vehicle; and
obtaining second position information based on the first position information, wherein the second position information is position information of the vehicle in a simulation scenario.

2. The method according to claim 1, wherein the obtaining second position information based on the first position information specifically comprises:
obtaining a position conversion relationship based on the first position information and simulation scenario information; and
obtaining the second position information based on the first position information and the position conversion relationship.

3. The method according to claim 2, wherein after the obtaining second position information based on the first position information, the method further comprises:
updating the simulation scenario information based on the second position information, wherein the simulation scenario information comprises traffic participant information; and
sending the simulation scenario information.

4. The method according to claim 2 or 3, wherein the simulation scenario information further comprises scenario trigger information.

5. The method according to claim 4, wherein the scenario trigger information is used to switch between test phases, the test phases comprise a first phase and a second phase, the vehicle uses a first planning and control algorithm in the first phase, and the vehicle uses a second planning and control algorithm in the second phase; and
the method further comprises: switching from the first phase to the second phase based on the scenario trigger information.

6. The method according to claim 4 or 5, wherein the scenario trigger information comprises at least one of the following: vehicle trigger information, traffic participant trigger information, or traffic signal trigger information.

7. The method according to claim 6, wherein the vehicle trigger information comprises a specified vehicle motion status, and the vehicle motion status comprises at least one of the following: position information of the vehicle, motion information of the vehicle, driving task information, or status information of a subsystem or a part of an ego-vehicle.

8. The method according to claim 6 or 7, wherein the traffic participant trigger information comprises at least one of the following: a specified motion status, a specified position, or a time of appearance in the simulation scenario.

9. The method according to any one of claims 6 to 8, wherein the traffic signal trigger information comprises at least one of the following: a specified traffic signal light signal, a specified traffic sign signal, a specified traffic marking signal, or a specified traffic manager signal.

10. The method according to any one of claims 1 to 9, wherein the simulation scenario is obtained based on a simulation scenario library, the simulation scenario library comprises a plurality of simulation scenarios, and the plurality of simulation scenarios comprise a simulation scenario obtained based on road test data.

11. A system for testing a vehicle, comprising:
an obtaining module, wherein the obtaining module is configured to obtain first position information, and the first position information is position information of the vehicle; and
a position conversion module, wherein the position conversion module is configured to obtain second position information based on the first position information, and the second position information is position information of the vehicle in a simulation scenario.

12. The system according to claim 11, wherein that the position conversion module is configured to obtain second position information based on the first position information specifically comprises:
the position conversion module is configured to obtain a position conversion relationship based on the first position information and simulation scenario information; and
the position conversion module is configured to obtain the second position information based on the first position information and the position conversion relationship.

13. The system according to claim 12, further comprising a simulation module and a sending module, wherein after the position conversion module obtains the second position information based on the first position information, the simulation module is configured to update the simulation scenario information based on the second position information, wherein the simulation scenario information comprises traffic participant information; and
the sending module is configured to send the simulation scenario information.

14. The system according to claim 12 or 13, wherein the simulation scenario information further comprises scenario trigger information.

15. The system according to claim 14, wherein the scenario trigger information is used to switch between test phases, the test phases comprise a first phase and a second phase, the vehicle uses a first planning and control algorithm in the first phase, and the vehicle uses a second planning and control algorithm in the second phase; and
the system further comprises: a switching module, and the switching module is configured to switch from the first phase to the second phase based on the scenario trigger information.

16. The system according to claim 14 or 15, wherein the scenario trigger information comprises at least one of the following: vehicle trigger information, traffic participant trigger information, or traffic signal trigger information.

17. The method according to claim 16, wherein the vehicle trigger information comprises a specified vehicle motion status, and the vehicle motion status comprises at least one of the following: position information of the vehicle, motion information of the vehicle, driving task information, or status information of a subsystem or a part of an ego-vehicle.

18. The system according to claim 16 or 17, wherein the traffic participant trigger information comprises at least one of the following: a specified motion status, a specified position, or a time of appearance in the simulation scenario.

19. The system according to any one of claims 16 to 18, wherein the traffic signal trigger information comprises at least one of the following: a specified traffic signal light signal, a specified traffic sign signal, a specified traffic marking signal, or a specified traffic manager signal.

20. The system according to any one of claims 11 to 19, wherein the simulation scenario is obtained based on a simulation scenario library, the simulation scenario library comprises a plurality of simulation scenarios, and the plurality of simulation scenarios comprise a simulation scenario obtained based on road test data.

21. A computer-readable storage medium, storing code or instructions, wherein when the code or the instructions are run, the method according to any one of claims 1 to 10 is performed.
